# EUROPÄISCHE PATENTSCHRIFT

(11) **EP 3 424 072 B1**
(45) Veröffentlichungstag und Bekanntmachung des Hinweises auf die Patenterteilung: **11.08.2021**
(21) Anmeldenummer: 17708731.9
(22) Anmeldetag: 01.03.2017
(51) Int. Cl.: H01L 21/60, H01L 23/473, H01L 23/538, H01L 23/482, H01L 21/56

(54) **VERFAHREN ZUR HERSTELLUNG EINES HALBLEITERBAUELEMENTS UND HALBLEITERBAUELEMENT**
METHOD FOR PRODUCING A SEMICONDUCTOR COMPONENT AND SEMICONDUCTOR COMPONENT
PROCÉDÉ DE PRODUCTION D'UN COMPOSANT À SEMI-CONDUCTEUR ET COMPOSANT À SEMI-CONDUCTEUR

(30) Priorität: 02.03.2016 DE 102016203453
(43) Veröffentlichungstag der Anmeldung: 09.01.2019
(73) Patentinhaber: Fraunhofer-Gesellschaft zur Förderung der angewandten Forschung e.V., 80686 München (DE)
(72) Erfinder: OPPERMANN, Hans-Hermann, 13088 Berlin (DE); ZOSCHKE, Kai, 13089 Berlin (DE); MANIER, Charles-Alix, 10551 Berlin (DE); WILKE, Martin, 10715 Berlin (DE); TEKIN, Tolga, 13353 Berlin (DE); GERNHARDT, Robert, 12619 Berlin (DE)
(74) Vertreter: Pfenning, Meinig & Partner mbB
(86) Internationale Anmeldenummer: PCT/EP2017/054727
(87) Internationale Veröffentlichungsnummer: WO 2017/148991

(56) Entgegenhaltungen:
- WO-A2-02/49103
- DE-A1-102012 107 696
- US-A1- 2013 154 082
- US-A1- 2015 262 984
- US-B1- 6 423 570

## Beschreibung

Die Anmeldung betrifft ein Verfahren zur Herstellung eines Halbleiterbauelements gemäß dem Oberbegriff des Anspruchs 1. Außerdem betrifft die Anmeldung ein Halbleiterbauelement.

Halbleiterbauelemente und Verfahren zur Herstellung eines Halbleiterbauelements sind beispielhaft aus US2013/154082, WO02/49103, US6423570, US2015/262984 und DE 10 2012 107696 bekannt. Bei gängigen Verfahren zur Herstellung elektronischer Bauelemente ist es vorgesehen, zunächst ein Trägermaterial mit einer Aussparung herzustellen. Anschließend wird das Trägermaterial mit einer Unterseite auf einer Klebefolie angeordnet und ein aus einem Halbleiterwafer herausgetrennter Halbeiterchip wird in der Aussparung auf der Klebefolie angeordnet. Der Halbleiterwafer weist an seiner Unterseite typischerweise elektrisch aktive Bereiche auf. Der Halbleiterchip wird anschließend in eine Vergussmasse eingegossen, so dass der Halbleiterchip mit dem Trägermaterial verbunden und in der Aussparung fixiert ist. Daraufhin wird die Klebefolie abgelöst und es wird mittels Dünnschichttechnologie eine Umverdrahtungslage auf der Unterseite des Trägers und einer Unterseite des Halbleiterchips hergestellt. Die Umverdrahtungslage weist Leiterbahnen auf und stellt einen elektrisch leitfähigen Kontakt zwischen den elektrisch aktiven Bereichen des Halbeiterchips und gegebenenfalls auf der Umverdrahtungslage vorgesehenen Anschlussstellen zur Verbindung des Halbleiterchips mit weiteren Bauelementen her. Die Anschlussstellen, wie beispielsweise Kontaktpads, Lötkontakte oder Steckerkontakte, können hierbei über eine Fläche der Umverdrahtungslage verteilt sein, die deutlich größer ist als eine Fläche des Halbleiterchips.

Das oben beschriebene Herstellungsverfahren eignet sich insbesondere, wenn der Halbleiterchip lediglich an seiner Unterseite zu kontaktierende elektrische aktive Bereiche aufweist. Ungeeignet ist das Verfahren jedoch, wenn Halbleiterchips Verwendung finden sollen, die einer elektrischen Kontaktierung an ihrer Oberseite oder beispielsweise einer optischen Ein- oder Auskopplung bedürfen. Ein weiteres Problem, welches bei einer Verwendung derart hergestellter elektronischer Bauelemente häufig auftritt, ist eine unzureichende Abfuhr einer vom Halbeiterchip im Betrieb erzeugten Wärme.

Aufgabe der vorliegenden Anmeldung ist es, ein Verfahren zur Herstellung eines Halbleiterbauelements vorzuschlagen, durch das die oben genannten Nachteile bekannter Verfahren vermindert beziehungsweise ausgeräumt werden. Außerdem liegt der Anmeldung die Aufgabe zugrunde, ein entsprechendes Halbleiterbauelement vorzuschlagen.

Diese Aufgaben werden gelöst durch ein Verfahren mit den Merkmalen des Anspruchs 1 sowie durch ein elektronisches Bauelement mit den Merkmalen eines nebengeordneten Anspruchs. Vorteilhafte Weiterbildungen ergeben sich mit den Merkmalen der abhängigen Ansprüche.

Das vorgeschlagene Verfahren zur Herstellung eines Halbleiterbauelements umfasst ein Bereitstellen eines flächigen Trägers mit einer Oberseite und einer Unterseite, wobei der Träger eine durchgehende Aussparung aufweist, die zwischen der Oberseite und der Unterseite verläuft. In einem weiteren Schritt wird eine Halbleiteranordnung bereitgestellt. Die Halbleiteranordnung weist einen Halbleiterchip auf, der an einer Unterseite elektrisch und/oder optisch aktive Bereiche umfasst. Anschließend wird die Halbleiteranordnung in der Aussparung angeordnet, derart dass eine Unterseite der Halbleiteranordnung und die Unterseite des Trägers in einer gemeinsamen Ebene verlaufen. Daraufhin wird die Halbleiteranordnung mit einer Vergussmasse so vergossen, dass die Halbleiteranordnung mit dem Träger stoffschlüssig verbunden wird. Die Halbleiteranordnung bildet mit dem Träger und der Vergussmasse ein Halbleitersystem. Anschließend wird das Halbleitersystem durch Schleifen von oben so ausgedünnt, dass eine Oberseite des Trägers und eine Oberseite der Halbleiteranordnung in einer gemeinsamen Ebene verlaufen.

Das Verfahren eignet sich zur Herstellung eines Halbleiterbauelements, das den flächigen Träger mit der Oberseite und der Unterseite umfasst, wobei der Träger die durchgehende Aussparung aufweist, die zwischen der Oberseite und der Unterseite verläuft. Das Halbleiterbauelement umfasst ferner die Halbleiteranordnung mit dem Halbleiterchip, der an der Unterseite die elektrisch und/oder optisch aktiven Bereiche umfasst, und die Vergussmasse, durch die die Halbleiteranordnung mit dem Träger stoffschlüssig verbunden ist. Die Unterseite der Halbleiteranordnung und die Unterseite des Trägers verlaufen in einer gemeinsamen Ebene und die Oberseite des Trägers und die Oberseite der Halbleiteranordnung verlaufen ebenfalls in einer gemeinsamen Ebene. In typischen Ausführungen bildet die Unterseite des Halbleiterchips die Unterseite der Halbleiteranordnung. Typischerweise ist die Oberseite und/oder die Unterseite des Halbleitersystems also planar beziehungsweise eben.

Das Halbleiterbauelement kann beispielsweise ein elektronisches Bauelement und/oder ein optisches Bauelement sein. Die elektrisch und/oder optisch aktiven Bereiche weisen beispielsweise photonisch integrierte Schaltungen (PIC), integrierte elektronische Schaltungen; diskrete elektronische Halbleiterbauelemente wie beispielsweise Dioden oder Transistoren (zum Beispiel GaN- oder SiC-basiert, insbesondere Bipolartransistoren mit isolierten Gate-Elektroden); optoelektronische Bauelemente wie Laserdioden, Photodioden oder Imagesensoren; und/oder photonische Bauelemente (beispielsweise Silizium-basiert).

Im Unterschied zu dem eingangs beschriebenen bekannten Verfahren ist die Oberseite der Halbleiteranordnung bei einer Verwendung des vorgeschlagenen Herstellungsverfahrens zugänglich. Es kann in manchen Ausführungen auch vorgesehen sein, dass eine Oberseite des Halbleiterchips nach dem Ausdünnen zugänglich ist. In diesem Fall kann beispielsweise eine Ein- oder Auskopplung von optischen Signalen über die Oberseite des Halbleiterchips erfolgen, was eine Vielzahl optoelektronischer oder photonischer Anwendungen ermöglicht. In typischen Ausführungen erfolgt eine Ein- und Auskopplung von optischen Signalen über die Unterseite des Halbleiterchips. Für eine optische Auskopplung auf der Oberseite beziehungsweise auf der Unterseite kann das Halbleiterbauelement auf der Ober- beziehungsweise Unterseite des Halbleitersystems beispielsweise optische Wellenleiter, beispielsweise Polymer-Wellenleiter, aufweisen. Es kann außerdem vorgesehen sein, dass der Halbleiterchip ebenfalls optische Wellenleiter aufweist, die evaneszent oder adiabatisch optisch an die Wellenleiter auf der Ober- beziehungsweise Unterseite des Halbleitersystems gekoppelt sind.

In typischen Ausführungen wird eine Höhe der Halbleiteranordnung infolge des Materialabtrags beim Ausdünnen des Halbleitersystems um mindestens 10 µm, vorzugsweise mindestens 50 µm, und/oder höchstens 500 µm, vorzugsweise höchstens 200 µm, verringert.

In weiteren Ausführungen kann es vorgesehen sein, dass die Oberseite der Halbleiteranordnung nach dem Ausdünnen des Halbleitersystems zumindest bereichsweise durch einen wärmeleitfähigen Kontakt mit einem Kühlkörper verbunden wird. Bei dem Kühlkörper kann es sich beispielsweise um einen metallischen oder einen keramischen Wärmespreizer handeln. Indem das Halbleitersystem so ausgedünnt wird, dass eine Oberseite des Trägers und eine Oberseite der Halbleiteranordnung in einer gemeinsamen Ebene verlaufen, kann der Kühlkörper auf einfache Weise sowohl mit der Oberseite der Halbleiteranordnung als auch mit der Oberseite des Trägers wärmeleitend verbunden werden. Hierdurch kann eine besonders effiziente Wärmeabfuhr von dem Halbleiterchip über die Oberseite der Halbleiteranordnung und die Oberseite des Trägers erreicht werden.

Es kann auch vorgesehen sein, dass die Oberseite der Halbleiteranordnung nach dem Ausdünnen des Halbleitersystems zumindest bereichsweise mit einem elektrisch leitfähigen Kontakt verbunden wird, der mit einer Oberseite des Halbleiterchips zumindest bereichsweise elektrisch leitfähig verbunden wird. Somit eignet sich das vorgeschlagene Verfahren insbesondere für Halbleiterbauelemente mit Halbleiterchips, insbesondere vertikal aufgebauten Halbleiterchips, die eine Rückseitenkontaktierung an ihrer Oberseite benötigen. Hierbei kann es sich beispielsweise um Dioden oder Feldeffekttransistoren mit Substratkontaktierungen handeln. Indem das Halbleitersystem so ausgedünnt wird, dass eine Oberseite des Trägers und eine Oberseite der Halbleiteranordnung in einer gemeinsamen Ebene verlaufen, können hierbei bekannte Verfahren zur Herstellung des elektrisch leitfähigen Kontaktes Verwendung finden, die sich insbesondere für planare Geometrien eignen, wie beispielsweise eine Dünnfilmtechnologie zur Herstellung eines löt- oder sinterfähigen Rückseitenkontakts oder einer Umverdrahtungslage.

Damit, dass die Oberseiten der Halbleiteranordnung und des Trägers in einer gemeinsamen Ebene verlaufen, ist gemeint, dass eine Ebene, die durch die meisten Punkte auf der Oberseite der Halbleiteranordnung verläuft, im Wesentlichen nicht gegenüber einer Ebene, die durch die meisten Punkte auf der Oberseite des Trägers verläuft, verkippt ist und außerdem gegenüber dieser Ebene keinen Versatz aufweist. In einer maximal verkippten Richtung schließen die entsprechenden Ebenen typischerweise einen Winkel von höchstens 5 Grad, vorzugsweise höchstens 2 Grad, ein. Ein Versatz der Ebenen beträgt im Bereich der Halbleiteranordnung höchstens 10 µm, vorzugsweise höchstens 5 µm, besonders vorzugsweise höchstens 2 µm. Analog gilt dies für die Unterseiten der Halbleiteranordnung und des Trägers.

Typischerweise sind die Oberseiten und Unterseiten des Trägers und der Halbleiteranordnung nicht vollständig planar. Es existiert aber typischerweise eine gemeinsame Ebene, zu der mindestens 90%, vorzugsweise mindestens 95%, von auf der Oberseite des Trägers und auf der Oberseite der Halbleiteranordnung befindlichen Punkten einen senkrecht zur gemeinsamen Ebene gemessenen Abstand von höchstens 5 µm, vorzugsweise höchstens 2 µm, besonders vorzugsweise höchstens 1 µm, aufweisen. Analog gilt dies für die Unterseiten der Halbleiteranordnung und des Trägers.

In typischen Ausführungen ist zwischen der Halbleiteranordnung und dem Träger ein Spalt ausgebildet. Die Aussparung im Träger ist in der Regel so ausgebildet, dass sich ein möglichst kleiner Spalt mit einer maximalen Spaltbreite von höchstens 200 µm, vorzugsweise höchstens 100 µm, ergibt. Der Spalt ist nach dem Vergießen der Halbleiteranordnung zumindest bereichsweise mit Vergussmasse gefüllt. Die Vergussmasse weist nach dem Ausdünnen des Halbleitersystems typischerweise ebenfalls eine Oberseite auf, die mit den Oberseiten des Trägers und der Halbleiteranordnung in einer gemeinsamen Ebene verläuft. Die Vergussmasse kann beispielsweise Polyimid und/oder Kunstharz und/oder Benzocyclobuten aufweisen.

Es ist vorgesehen, dass das Ausdünnen des Halbleitersystems durch Entfernen von Material von der Halbleiteranordnung erfolgt. Es kann beispielsweise vorgesehen sein, dass hierbei von oben in die Halbleiteranordnung hineingeschliffen wird, ohne dass in den Träger hineingeschliffen wird. In einigen Ausführungen kann es vorgesehen sein, dass beim Schleifen lediglich Material von der Halbleiteranordnung entfernt wird. Wenn in die Halbleiteranordnung hineingeschliffen wird, so weist die Halbleiteranordnung anschließend eine geschliffene Oberseite auf. Das Halbleitersystem kann aber auch durch Materialabtrag bzw. Materialentfernung von dem Träger und von der Halbleiteranordnung ausgedünnt werden. Wenn in den Träger hineingeschliffen wird, so weist der Träger anschließend eine geschliffene Oberseite auf. In einer anderen typischen Ausführung wird sowohl in den Träger als auch in die Halbleiteranordnung von oben hineingeschliffen. Durch ein gemeinsames Schleifen der Halbleiteranordnung und des Trägers kann eine planare Oberseite des Halbleitersystems gefertigt werden. Beispielsweise kann es vorgesehen sein, dass die Oberseite der Halbleiteranordnung durch ein Substrat des Halbleiterchips gebildet wird und dass der Halbleiterchip durch Materialabtrag von dem Substrat ausgedünnt wird. Insbesondere wenn der Halbleiterchip auf seiner Oberseite keine empfindlichen elektrisch und/oder optisch aktiven Bereiche aufweist, deren mögliche Zerstörung durch das Schleifen unerwünscht wäre, eignet sich diese Ausführung, um auf einfache Weise zu erreichen, dass die Oberseite des Trägers und die Oberseite der Halbleiteranordnung in einer gemeinsamen Ebene verlaufen.

Es ist vorgesehen, dass die Halbleiteranordnung an einer Oberseite eine Opferschicht aufweist, die beim Schleifen ausgedünnt wird. Dadurch wird die geschliffene Oberseite der Halbleiteranordnung durch die geschliffene Opferschicht gebildet. Durch Verwendung der Opferschicht kann das Ausdünnen der Halbleiteranordnung durchgeführt werden, ohne dass in den Halbleiterchip hineingeschliffen werden muss. Die Verwendung einer Opferschicht eignet sich insbesondere dann, wenn die Oberseite des Halbleiterchips elektrisch aktiv ist und/oder der Halbleiterchips an seiner Oberseite einen Rückseitenkontakt aufweist. Darüber hinaus kann insbesondere bei Halbleiterchips, die umweltbelastende Materialien, wie beispielsweise GaAs umfassen, verhindert werden, dass beim Schleifen umweltbelastender Abfall oder toxischer Schleifstaub produziert werden, welche insbesondere eine potentielle Gesundheitsgefährdung für Personen darstellen.

Die Opferschicht weisst metallisches oder halbleitendes Material auf. Insbesondere Materialien mit einer hohen Wärmeleitfähigkeit eignen sich für die Opferschicht, da die Opferschicht in diesem Fall eine effiziente Wärmeabfuhr von dem Halbleiterchip gewährleisten kann. Darüber hinaus kann in gewissen Ausführungen eine elektrische Leitfähigkeit der Opferschicht erwünscht sein, beispielsweise damit die Opferschicht zur elektrischen Kontaktierung des Halbleiterchips verwendet werden kann. Metallische Opferschichten zeichnen sich beispielsweise durch eine hohe Wärmeleitfähigkeit und eine ebenfalls hohe elektrischen Leitfähigkeit aus.

Die Opferschicht kann beispielsweise auf einer Oberseite des Halbleiterchips abgeschieden werden. Hierbei können gängige Verfahren wie beispielsweise eine galvanische Abscheidung, ein Aufdampfen oder ein Sputterverfahren angewendet werden. Hierbei eignen sich das Aufdampfen und das Sputterverfahren typischerweise für geringe Dicken der Opferschicht von etwa 1 µm und weniger. Bei größeren Dicken eignet sich die galvanische Abscheidung. Durch ein Abscheiden der Opferschicht kann in der Regel eine gute Wärmeübertragung zwischen dem Halbleiterchip und der Opferschicht erreicht werden.

Es kann aber auch vorgesehen sein, dass die Opferschicht auf einer Oberseite des Halbleiterchips befestigt wird. Zum Befestigen der Opferschicht auf der Oberseite des Halbleiterchips können verschiedene bekannte Chipbonding-Verfahren wie beispielsweise Löten, Transient Liquid Phase Bonding, Thermokompressionsbonden, Ultraschallverschweißen, Sintern oder Kleben angewendet werden. Gegenüber dem Abscheiden der Opferschicht eignet sich das Befestigen insbesondere, wenn relativ dicke Opferschichten auf einfache Weise bereitgestellt werden sollen.

Durch das Schleifen in die Opferschicht beziehungsweise in den Halbleiterchip können sehr glatte Oberseiten des Halbleitersystems im Vergleich zu alternativen Lösungen erzeugt werden. Eine alternative Lösung könnte beispielsweise vorsehen, zum Erzeugen einer planaren Oberseite eines Halbleitersystems anstatt des Schleifens eine Opferschicht auf den Halbleiterchip aufzubringen, die aufgrund ihrer Dicke einen bündigen Abschluss der Halbeiteranordnung mit der Oberseite des Trägers erzeugt. In diesem Fall wäre die Oberseite des Halbleitersystems jedoch beispielsweise aufgrund von Schrägschnitten der Halbleiterwafer weniger planar als im Fall einer Verwendung des vorgeschlagenen Herstellungsverfahrens.

In einigen Ausführungen wird vor dem Vergießen ein Hilfsträger bereitgestellt, auf dem der Träger angeordnet wird. Die Halbleiteranordnung kann in der Aussparung des Trägers auf dem Hilfsträger angeordnet werden. Hierbei kann beispielsweise zuerst die Halbleiteranordnung oder zuerst der Träger auf dem Hilfsträger angeordnet werden. Der Träger zeichnet sich durch eine im Wesentlichen planare Oberseite aus. Somit lässt sich auf einfache Weise erreichen, dass die Unterseite der Halbleiteranordnung und die Unterseite des Trägers in einer gemeinsamen Ebene verlaufen. Der Hilfsträger kann beispielsweise als Glasträger ausgeführt sein. Es kann beispielsweise auch vorgesehen sein, dass der Hilfsträger an einer Oberseite eine Klebefolie oder einen Klebefilm aufweist, auf der die Halbleiteranordnung und der Träger vor dem Vergießen angeordnet und durch die die Halbleiteranordnung und der Träger vor dem Vergießen fixiert werden.

Es kann vorgesehen sein, dass mindestens eine weitere Halbleiteranordnung bereitgestellt wird, die in der Aussparung angeordnet und in die Vergussmasse vergossen wird. Die weitere Halbleiteranordnung kann alle der hier in Hinblick auf die Halbleiteranordnung beschriebenen Merkmale aufweisen. Hierbei können die Halbleiteranordnung und die weitere Halbleiteranordnung beispielsweise identische oder unterschiedliche Höhen aufweisen und/oder identische oder unterschiedliche Materialien umfassen.

Das Bereitstellen des Trägers umfasst typischerweise den Schritt des Einbringens der Aussparung in den Träger. Das Einbringen der Aussparung kann beispielsweise mittels Trockenätzen oder Laserschneiden erfolgen.

Der Träger weist typischerweise ein metallisches oder halbleitendes Material, insbesondere Silizium, auf. Insbesondere kann es vorgesehen sein, dass der Träger dasselbe Material wie der Halbleiterchip und/oder die gegebenenfalls vorgesehene Opferschicht aufweist. Daraus resultierende gleiche oder zumindest ähnliche Wärmeausdehnungskoeffizienten des Trägers und des Halbleiterchips und/oder der Opferschicht können mechanische Spannungen innerhalb des Halbleiterbauelements infolge einer Erwärmung oder Abkühlung reduzieren sowie eine damit gegebenenfalls einhergehende Schädigung des Halbleiterbauelements vermindern. In anderen Ausführungen kann der Träger beispielsweise Keramik oder Glas umfassen.

In einem weiteren Schritt kann eine Umverdrahtungslage auf einer Unterseite des Halbleitersystems hergestellt werden, wobei die Umverdrahtungslage Leiterbahnen umfasst, die mit den elektrisch und/oder optisch aktiven Bereichen des Halbleiterchips zumindest bereichsweise elektrisch leitfähig verbunden werden.

Allgemein können die hier in Bezug auf die Oberseite oder Unterseite des Halbleitersystems beschriebenen Maßnahmen zur elektrischen und/oder thermischen Kontaktierung in analoger Weise auch auf der Unterseite beziehungsweise Oberseite des Halbleitersystems vorgenommen werden.

Ausführungsbeispiele werden nachfolgend anhand der Abbildungen beschrieben. Es zeigen
- Fign. 1-6: schematische Querschnitte während aufeinanderfolgender Verfahrensschritte bei der Herstellung eines Halbleiterbauelements,
- Fig. 7: eine Aufsicht auf ein in Fig. 6 dargestelltes Halbleitersystem,
- Fign. 8 und 9: schematische Ansichten während weiterer Verfahrensschritte bei der Herstellung eines Halbleiterbauelements die nicht Teil der beanspruchten Erfindung sind und
- Fign. 10-13: schematische Ansichten von Halbleiterbauelementen gemäß weiteren Ausführungen.

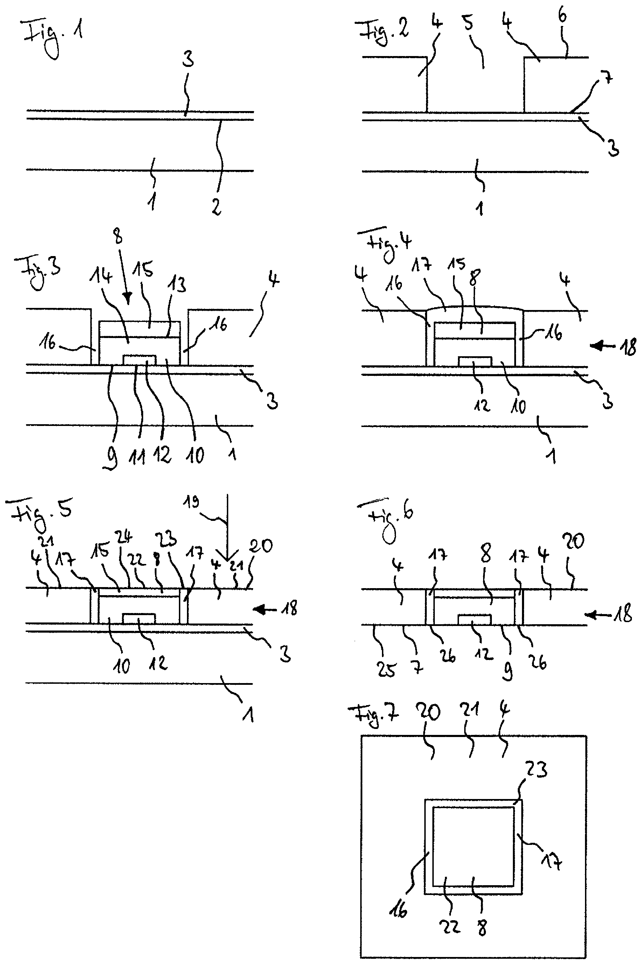

In Fign. 1 bis 6 ist ein Verfahren zur Herstellung eines Halbleiterbauelements illustriert. Wie Fig. 1 zeigt, wird bei diesem Verfahren zunächst ein Hilfsträger 1 bereitgestellt, dessen Oberseite 2 mit einem Klebefilm 3 versehen ist. Der Klebefilm 3 kann beispielsweise auf die Oberseite 2 des Hilfsträgers 1 geschleudert werden. Der Hilfsträger 1 kann beispielsweise als Glasträger ausgebildet sein. In einem weiteren Verfahrensschritt wird ein flächiger Träger 4, beispielsweise ein Silizium-Wafer, auf dem Klebefilm 3 angeordnet.

Wie in Fig. 2 dargestellt ist, weist der Träger 4 eine Aussparung 5 auf, die zwischen einer Oberseite 6 des Trägers 4 und einer Unterseite 7 des Trägers 4 verläuft. Wiederkehrende Merkmale sind in dieser und den folgenden Abbildungen mit den gleichen Bezugszeichen versehen. Die Aussparung 5 kann zuvor mittels gängiger Verfahren, beispielsweise durch Trockenätzen oder Laserschneiden, in den Träger 4 eingebracht werden. Anschließend wird eine Halbleiteranordnung 8 bereitgestellt.

Die Halbleiteranordnung 8 wird wie in Fig. 3 dargestellt auf dem Klebefilm 3 und in der Aussparung 5 des Trägers 4 angeordnet, so dass die Halbleiteranordnung 8 seitlich von dem Träger 4 umgeben ist. Hierbei kann es vorgesehen sein, dass die Halbleiteranordnung 8 eine geringere Höhe aufweist als der Träger 4, so dass der Träger 4 die Halbleiteranordnung 8 nach dem Anordnen der Halbleiteranordnung 8 in der Aussparung 5 überragt, wie in Fig. 3 dargestellt ist. In anderen Ausführungen kann es aber auch vorgesehen sein, dass die Halbleiteranordnung 8 nach dem Anordnen den Träger 4 überragt.

Die Halbleiteranordnung 8 weist an ihrer Unterseite 9 einen Halbleiterchip 10 auf, der an seiner Unterseite 11 elektrisch und/oder optisch aktive Bereiche 12, im Folgenden als aktive Bereiche bezeichnet, umfasst. An seiner Oberseite 13 kann der Halbleiterchip 10 beispielsweise ein Chipsubstrat 14 aufweisen, welches elektrisch leitfähig oder isolierend beziehungsweise semi-isolierend ausgebildet sein kann. Der Halbleiterchip 10 kann beispielsweise integrierte Schaltkreise und/oder photonisch integrierte Schaltungen umfassen. In den aktiven Bereichen 12 des Halbleiterchips 10 können beispielsweise Metallisierungen zur elektrischen Kontaktierung der integrierten Schaltkreise und/oder der photonisch integrierten Schaltungen vorgesehen sein.

Zusätzlich umfasst die Halbleiteranordnung 8 eine Opferschicht 15, die auf die Oberseite 13 des Halbleiterchips 10, beispielsweise mittels Ultraschallverschweißen, gebondet wurde. Es kann in anderen Ausführungen vorgesehen sein, dass die Opferschicht 15 auf dem Halbleiterchip 10 beispielsweise galvanisch abgeschieden wird. Die Opferschicht 15 weist eine hohe Wärmeleitfähigkeit auf. Des Weiteren weist eine Grenzfläche zwischen der Opferschicht 15 und der Oberseite 13 des Halbleiterchips 10 eine hohe Wärmeleitfähigkeit auf. Die Opferschicht 15 kann beispielsweise ein Metall aufweisen oder vollständig aus einem Metall gebildet sein. Zwischen der Halbleiteranordnung 8 und dem Träger 4 ist ein Spalt 16 ausgebildet.

In einem weiteren Schritt wird die Halbleiteranordnung 8 mit einer Vergussmasse 17, beispielsweise mit Kunstharz, vergossen, wie in Fig. 4 dargestellt ist. Bei dem Vergießen wird der Spalt 16 mit der Vergussmasse 17 ausgefüllt. Außerdem bedeckt die Vergussmasse 17 nach dem Vergießen die Halbleiteranordnung 8. In weiteren Ausführungen bedeckt die Vergussmasse 17 nach dem Vergießen zusätzlich zu der Halbleiteranordnung 8 auch die Oberseite 6 des Trägers 4. Das Vergießen kann beispielsweise bei erhöhter Temperatur oder erhöhtem Druck erfolgen. Durch das Vergießen wird eine stoffschlüssige Verbindung zwischen der Vergussmasse 17 und der Halbleiteranordnung 8 sowie zwischen der Vergussmasse 17 und dem Träger 4 erzeugt. Der Träger 4, die Vergussmasse 17 und die Halbleiteranordnung 8 bilden nach dem Vergießen ein Halbleitersystem 18.

In einem weiteren Schritt wird das Halbleitersystem 18 von oben in einer in Fig. 5 schematisch dargestellten Richtung 19 abgetragen. In dem dargestellten Ausführungsbeispiel wird hierbei zunächst Material sowohl von dem Träger 4 als auch der Vergussmasse 17 abgetragen. Bei größerer Schleiftiefe wird zusätzlich Material von der Halbleiteranordnung 8 abgetragen, so dass die Opferschicht 15 wie in Fig. 5 dargestellt ausgedünnt wird. Wenn die Halbleiteranordnung 8, wie in anderen Ausführungen vorgesehen, eine größere Höhe aufweist als der Träger 4, dann wird beim Schleifen Material von der Halbleiteranordnung 8 abgetragen bevor Material vom Träger 4 abgetragen wird. Es kann in einigen Ausführungen aber auch vorgesehen sein, dass beim Schleifen kein Material vom Träger 4 entfernt wird. Insbesondere kann es vorgesehen sein, dass beim Schleifen lediglich Material von der Halbleiteranordnung 8 entfernt wird. Hierbei wird in der Regel Material von der Opferschicht 15 entfernt.

Nach dem Schleifen weist das Halbleitersystem 18 eine plane, beziehungsweise glatte Oberseite 20 auf. Die Oberseite 20 des Halbleitersystems 18 wird bereichsweise gebildet durch eine geschliffene Oberseite 21 des Trägers 4, eine geschliffene Oberseite 22 der Hableiteranordnung 8 sowie durch eine geschliffene Oberseite 23 der Vergussmasse 17. Die Oberseite 22 der Halbleiteranordnung 8 wird gebildet durch eine geschliffene Oberseite 24 der Opferschicht 15. Die genannten geschliffenen Oberseiten 21, 22, 23, 24 verlaufen in einer gemeinsamen Ebene.

In einem nächsten Schritt werden der Hilfsträger 1 und der Klebefilm 3 wie in Fig. 6 gezeigt von dem Halbleitersystem 18 abgelöst, was beispielsweise durch Laserablation durchgeführt werden kann, indem der Klebefilm 3 durch den Hilfsträger 1 hindurch mit einem Laser bestrahlt wird.. Eine Unterseite 25 des Halbleitersystems 18 wird bereichsweise gebildet durch die Unterseite 7 des Trägers 4, die Unterseite 9 der Halbleiteranordnung 8 sowie durch eine Unterseite 26 der Vergussmasse 17. Dadurch dass der Träger 4 und die Halbleiteranordnung 8 auf dem Klebefilm 3 angeordnet und auf dieser mit der Vergussmasse 17 vergossen wurden, verlaufen die genannten Unterseiten 7, 9, 26 in einer gemeinsamen Ebene.

Fig. 7 zeigt eine Aufsicht auf die Oberseite 20 des Halbleitersystems 18. Die Oberseite 21 des Trägers 4 umgibt die Oberseite 22 der Hableiteranordnung 8. Zwischen der Oberseite 21 des Trägers 4 und der Oberseite 22 der Hableiteranordnung 8 ist der Spalt 16 ausgebildet, der durch die Vergussmasse 17 ausgefüllt wird.

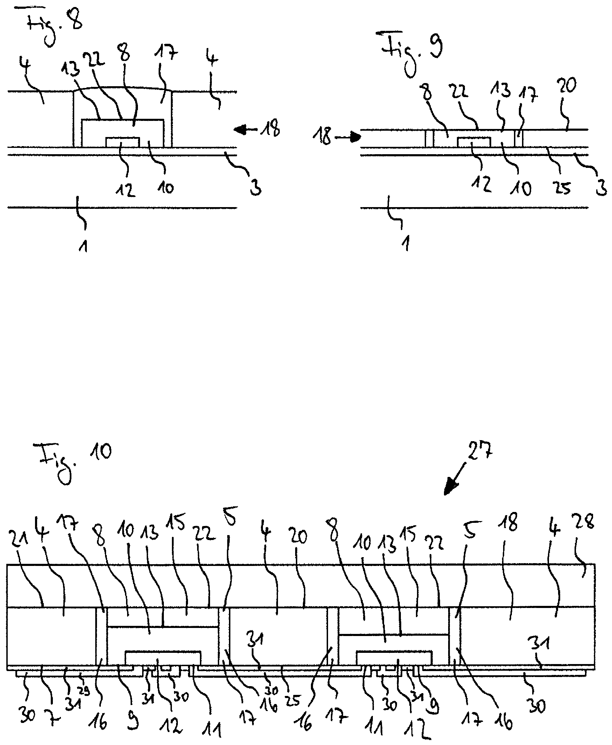

Eine nicht erfindungsgemässe Abwandlung des Verfahrens ist in den Fign. 8 und 9 dargestellt. Dieses abgewandelte Verfahren unterscheidet sich von dem oben beschriebenen Verfahren darin, dass die Halbleiteranordnung 8 keine Opferschicht 15 aufweist. Vor dem Schleifen des Halbleitersystems 18, bei dem der Träger 4, die Vergussmasse 17 und der Halbleiterchip 10 von oben ausgedünnt werden, bildet die Oberseite 13 des Halbleiterchips 10 die Oberseite 22 der Halbleiteranordnung 8, wie in Fig. 8 dargestellt ist. Fig. 9 zeigt das Halbleitersystem 18 nach dem Schleifen. Hierbei bildet die nun abgeschliffene Oberseite 13 des Halbleiterchips 10 weiterhin die Oberseite 22 der abgeschliffenen Halbleiteranordnung 8 und gleichzeitig einen Bereich der Oberseite 20 des Halbleitersystems 18.

Zur Herstellung eines fertiggestellten Halbleiterbauelements können in weiteren Schritten thermische oder elektrische Kontakte auf der Oberseite 20 und/oder auf der Unterseite 25 des Halbleitersystems 18 erzeugt werden.

Ein gemäß dem beschriebenen Verfahren hergestelltes Halbleiterbauelement 27 zeigt Fig. 10. Dieses umfasst einen Träger 4 mit zwei Aussparungen 5, in denen jeweils eine Halbleiteranordnung 8 angeordnet ist. Der Träger 4 ist in dem vorliegenden Beispiel als Silizium-Rahmen ausgeführt. Die zwei Halbleiteranordnungen 8 umfassen jeweils einen Halbleiterchip 10, beispielsweise einen Galliumnitrid-Chip, und eine Opferschicht 15, wobei die Opferschichten 15 auf einer Oberseite 13 eines jeweiligen der Halbleiterchips 10 angeordnet sind und mit diesem thermisch leitfähig verbunden sind. Die Opferschichten 15 können beispielsweise als Metallsockel ausgeführt sein, die jeweils auf einen der Halbeiterchips 10 gebondet sind. Die Halbleiterchips 10 weisen jeweils an ihren Unterseiten 11 aktive Bereiche 12 auf.

Die Halbleiteranordnungen 8 sind in eine Vergussmasse 17 eingegossen, die Spalte 16 zwischen dem Träger 4 und den Halbleiteranordnungen 8 ausfüllt und den Träger 4 stoffschlüssig mit den Halbleiteranordnungen 8 verbindet. Unterseiten 9 und Oberseiten 22 der Halbleiteranordnungen 8 verlaufen in einer gemeinsamen Ebene mit Unterseiten 7 und Oberseiten 21 des Trägers 4.

Die Halbleiteranordnungen 8, die Vergussmasse 17 und der Träger 4 bilden ein Halbleitersystem 18, welches eine Oberseite 20 und eine Unterseite 25 aufweist. Zur Abfuhr von durch die Halbleiteranordnungen 8 erzeugter Betriebswärme ist auf der Oberseite 20 des Hableitersystems 18 ein Kühlkörper 28, beispielsweise ein Wärmespreizer aus einer Aluminiumnitrid-Keramik, angeordnet. Der Kühlkörper 28 kann beispielsweise weiterhin mit einem Luftkühler, einem Wasserkühler oder einem Metallgehäuse wärmeleitfähig verbunden sein. Der Kühlkörper 28 ist mit den Oberseiten 22 der Halbleiteranordnungen 8 und mit der Oberseite 21 des Trägers 4 durch einen thermisch leitfähigen Kontakt verbunden. Durch die planare Oberseite 20 des Halbeitersystems 18 kann eine große Nähe zwischen dem flächigen Kühlkörper 28 und den Oberseiten 22, 21 der Halbleiteranordnungen 8 und des Trägers 4 und somit ein effizienter Wärmeübergang zwischen dem Hableitersystem 18 und dem Kühlkörper 28 erreicht werden. Der thermisch leitfähige Kontakt kann beispielsweise zusätzlich über ein Thermal-Interface-Material, beispielsweise eine Wärmeleitpaste, verbessert werden.

Auf der Unterseite 25 des Halbleitersystems 18 ist eine Umverdrahtungslage 29 angeordnet. Die Umverdrahtungslage 29 dient einer räumlichen Umverteilung von elektrischen Kontaktierungen zu den Halbleiterchips 10 und umfasst dafür elektrisch leitfähige Leiterbahnen 30 und elektrisch isolierende Bereiche 31. Die Leiterbahnen 30 verbinden die elektrisch aktiven Bereiche 12 untereinander und/oder mit weiteren gegebenenfalls an der Umverdrahtungslage 29 vorgesehenen Anschlussstellen wie beispielsweise Kontaktpads oder Lotkugeln.

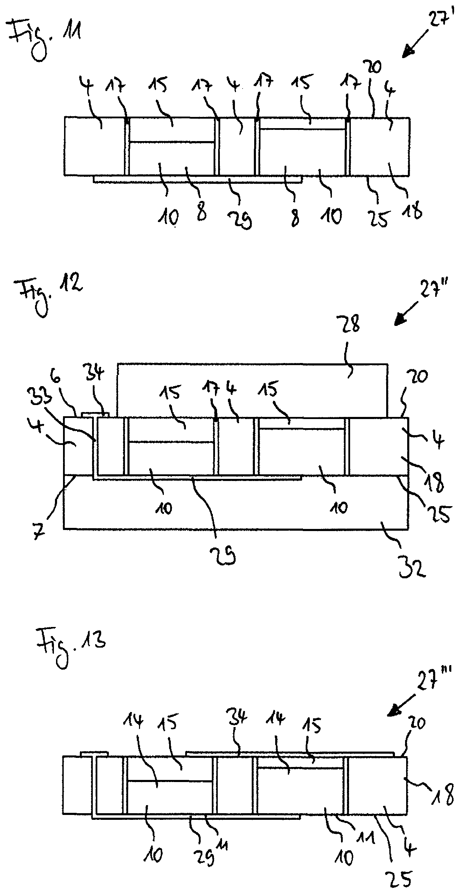

Ein weiteres Ausführungsbeispiel eines Halbleiterbauelements 27' ist in Fig. 11 dargestellt. In diesem Ausführungsbeispiel ist die Unterseite 25 des Halbleitersystems 18 mit einer Umverdrahtungslage 29 versehen, die mit Leiterbahnen in Form einer strukturierten Metallisierung versehen aufweist. Durch die Umverdrahtungslage 29 werden die nicht dargestellte aktive Bereiche der Hableiterchips 10 kontaktiert. Bei dem dargestellten Bauelement 27' kann es sich beispielsweise um ein Hochfrequenz-Modul handeln. Zusätzlich kann das Halbleiterbauelement 27' weitere Bauelemente wie beispielsweise Verstärker zum Betrieb einer Sendeantenne umfassen. Die weiteren Bauelemente können beispielsweise als Teil der Umverdrahtungslage 29 ausgeführt oder in den Träger 4 eingebettet sein. Die Umverdrahtungslage 29 wird typischerweise mittels Dünnfilmtechnik hergestellt und kann beispielsweise impedanzkontrollierte Leiterbahnen, Mikrostreifenleitungen oder Koplanarleitungen umfassen. Die Oberseite 20 des Halbleitersystems 18 eignet sich wie in dem zuvor beschriebenen Beispiel für eine Anbindung an einen Kühlkörper.

Fig. 12 zeigt eine weitere Ausführungsform eines Halbleiterbauelements 27". Dieses Halbleiterbauelement 27" weist im Gegensatz zu dem in Fig. 11 dargestellten Halbleiterbauelement 27' einen Kühlkörper 28 auf, der mit der Oberseite 20 des Hableitersystems 18 wärmeleitfähig verbunden ist. Darüber hinaus ist ein zweiter Kühlkörper 32 an der Unterseite 25 des Halbleitersystems 18 und an einer Unterseite der Umverdrahtungslage 29 angeordnet, so dass eine effiziente Wärmeabfuhr von dem Halbleitersystem 18 über dessen Oberseite 20 und über dessen Unterseite 25 erfolgen kann. Somit eignet sich dieses Ausführungsbeispiel insbesondere für Bauelemente der Leistungselektronik, beispielsweise zum Schalten oder Konvertieren von hohen Spannungen oder Strömen. Die Halbleiterchips 10 können beispielsweise silizium-, siliziumcarbid- oder galliumnitridbasiert sein und weisen typischerweise einen oder mehrere Transistoren und/oder Dioden auf. Außerdem weist der Träger 4 einen elektrisch leitfähigen Durchkontakt 33 auf, der zwischen der Oberseite 6 des Trägers 4 und der Unterseite 7 des Trägers 4 verläuft. Leiterbahnen der Umverdrahtungslage 29 sind elektrisch leitfähig mit dem Durchkontakt 33 verbunden. Auf der Oberseite 6 des Trägers 4 ist ferner ein mit dem Durchkontakt 33 elektrisch leitfähig verbundenes Kontaktpad 34 vorgesehen.

In Fig. 13 ist ein weiteres Ausführungsbeispiel eines Halbleiterbauelements 27"' dargestellt. Dieses Halbleiterbauelement 27'" unterscheidet sich von den davor beschriebenen Halbleiterbauelementen 27, 27', 27" dadurch, dass es neben der Umverdrahtungslage 29 eine zweite Umverdrahtungslage 34 aufweist, die auf der Oberseite 20 des Halbleitersystems 18 angeordnet ist und dessen Leiterbahnen elektrisch leitfähig mit den Opferschichten 15 verbunden sind. Die Halbleiterchips 10 weisen jeweils ein Chipsubstrat 14 auf, das elektrisch leitfähig ausgeführt ist. Die Opferschichten 15 sind ebenfalls elektrisch leitfähig ausgeführt und sind mit den Chipsubstraten 14 elektrisch leitfähig verbunden. Dadurch wird eine beidseitige elektrische Kontaktierung der Hableiterchips 10 erreicht. Die dargestellte Ausführungsform eignet sich somit für Halbleiterbauelement, deren Betrieb unter anderem eine substratseitige elektrische Kontaktierung eines Halbleiterchips voraussetzt. In typischen Ausführungen werden hierbei jeweils ein elektrischer Kontakt mit jedem der Chipsubstrate 14 und mehrere elektrische Kontakte mit den nicht dargestellten aktiven Bereichen an jeder der Unterseiten 11 der Halbleiterchips 10 hergestellt. Die Unterseiten 11 der Halbleiterchips 10 sind trotz einer bereichsweisen Kontaktierung durch die Umverdrahtungslage 29 von einer Unterseite des Halbleiterbauelements 27'" weitgehend frei zugänglich. Daher eignet sich diese Unterseite des Halbleiterbauelements 27"' beispielsweise für eine Auskopplung oder eine Einkopplung elektromagnetischer Strahlung aus den Hableiterchips 10 beziehungsweise in die Halbleiterchips 10. Die Halbleiterchips 10 können beispielsweise als Leuchtdioden, als oberflächenemittierende Laserdioden oder als Photodetektoren ausgeführt sein. Zusätzlich kann das Halbleiterbauelement 27'" an der Unterseite 25 des Hableitersystems 18 beispielsweise optische Wellenleiter aufweisen.

In den beschriebenen und weiteren Ausführungsbeispielen können die Opferschichten auf den Halbleiterchips abgeschieden oder an den Halbleiterchips befestigt werden. Die Opferschichten sind aus Metall oder halbleitendem Material gefertigt. In weiteren Ausführungen kann eine Halbleiteranordnung beispielsweise mehrere Halbeiterchips und eine Opferschicht oder umgekehrt mehrere Opferschichten und einen Halbleiterchip aufweisen. Hierbei sind typischerweise die mehreren Halbleiterchips oder Opferschichten auf derselben Seite der Opferschicht beziehungsweise des Halbleiterchips angeordnet.

Die Oberseite des Halbleitersystems kann in den beschriebenen und weiteren Ausführungsbeispielen nach dem Schleifen und vor dem Herstellen eines elektrischen oder thermischen Kontaktes auch mit einem feinkörnigen Schleifmittel poliert werden, um eine besonders glatte Oberseite des Halbleitersystems zu erzeugen. Anschließend oder alternativ kann es vorgesehen sein, dass die Oberseite des Halbleitersystems in einem weiteren Schritt durch die Herstellung von belotbaren Bereichen auf der Oberseite, beispielsweise durch eine Abscheidung von Cu, Ni/Au, Ti/Pt/Au, auf die elektrische oder thermische Anbindung vorbereitet wird.

## Patentansprüche

1. Verfahren zur Herstellung eines Halbeiterbauelements (27) mit den folgenden Schritten:
- Bereitstellen eines flächigen Trägers (4) mit einer Oberseite (6) und einer Unterseite (7), wobei der Träger (4) eine durchgehende Aussparung (5) aufweist, die zwischen der Oberseite (6) und der Unterseite (7) verläuft,
- Bereitstellen einer Halbleiteranordnung (8), die einen Halbleiterchip (10) aufweist, wobei der Halbleiterchip (10) an einer Unterseite (11) elektrisch und/oder optisch aktive Bereiche (12) umfasst,
- Anordnen der Halbleiteranordnung (8) in der Aussparung (5), derart dass eine Unterseite (9) der Halbleiteranordnung (8) und die Unterseite (7) des Trägers (4) in einer gemeinsamen Ebene verlaufen,
- Vergießen der Halbleiteranordnung (8) mit einer Vergussmasse (17), derart dass die Halbleiteranordnung (8) mit dem Träger (4) stoffschlüssig verbunden wird, wobei die Halbleiteranordnung (8) mit dem Träger (4) und der Vergussmasse (17) ein Halbleitersystem (18) bildet,- Ausdünnen des Halbleitersystems (18) durch Schleifen von oben, derart dass eine Oberseite (6) des Trägers (4) und eine Oberseite (22) der Halbleiteranordnung (8) in einer gemeinsamen Ebene verlaufen, wobei die Halbleiteranordnung (8) an einer Oberseite (22) eine Opferschicht (15) aufweist, die beim Schleifen ausgedünnt wird, **dadurch gekennzeichnet, dass** die Opferschicht (15) metallisches oder halbleitendes Material aufweist.

2. Verfahren nach Anspruch 1, **dadurch gekennzeichnet, dass** das Ausdünnen des Halbleitersystems (18) durch Entfernen von Material von der Halbleiteranordnung (8) erfolgt.

3. Verfahren nach einem der Ansprüche 1 oder 2, **dadurch gekennzeichnet, dass** das Ausdünnen des Halbleitersystems (18) durch Materialabtrag von dem Träger (4) und von der Halbleiteranordnung (8) erfolgt.

4. Verfahren nach einem der Ansprüche 1 bis 3, **dadurch gekennzeichnet, dass** das Bereitstellen der Halbleiteranordnung (8) den folgenden Schritt umfasst:
- Abscheiden der Opferschicht (15) auf einer Oberseite (13) des Halbleiterchips (10).

5. Verfahren nach einem der Ansprüche 1 bis 3, **dadurch gekennzeichnet, dass** das Bereitstellen der Halbleiteranordnung (8) den folgenden Schritt umfasst:
- Befestigen der Opferschicht (15) auf einer Oberseite (13) des Halbleiterchips (10).

6. Verfahren nach einem der Ansprüche 1 bis 5, **dadurch gekennzeichnet, dass** vor dem Vergießen ein Hilfsträger (1) bereitgestellt wird, auf dem der Träger (4) angeordnet wird, wobei die Halbleiteranordnung (8) beim Anordnen der Halbleiteranordnung (8) in der Aussparung (5) des Trägers (4) auf dem Hilfsträger (1) angeordnet wird.

7. Verfahren nach einem der Ansprüche 1 bis 6, **dadurch gekennzeichnet, dass** mindestens eine weitere Halbleiteranordnung (8) bereitgestellt wird, die in der Aussparung (5) angeordnet und in die Vergussmasse (17) vergossen wird.

8. Verfahren nach einem der Ansprüche 1 bis 7, **dadurch gekennzeichnet, dass** der Träger (4) ein metallisches oder halbleitendes Material, insbesondere Silizium, umfasst.

9. Verfahren nach einem der Ansprüche 1 bis 8, **dadurch gekennzeichnet, dass** die Oberseite (22) der Halbleiteranordnung (8) nach dem Ausdünnen des Halbleitersystems (18) zumindest bereichsweise durch einen wärmeleitfähigen Kontakt mit einem Kühlkörper (28) verbunden wird.

10. Verfahren nach einem der Ansprüche 1 bis 9, **dadurch gekennzeichnet, dass** die Oberseite (22) der Halbleiteranordnung (8) nach dem Ausdünnen des Halbleitersystems (18) zumindest bereichsweise mit einem elektrisch leitfähigen Kontakt verbunden wird, der mit einer Oberseite (13) des Halbleiterchips (10) zumindest bereichsweise elektrisch leitfähig verbunden wird.

11. Verfahren nach einem der Ansprüche 1 bis 10, **gekennzeichnet durch** den Schritt:
- Herstellen einer Umverdrahtungslage (29) auf einer Unterseite (25) des Halbleitersystems (18), wobei die Umverdrahtungslage (29) Leiterbahnen (30) umfasst, die mit den elektrisch und/oder optisch aktiven Bereichen (12) des Halbleiterchips (10) zumindest bereichsweise elektrisch leitfähig verbunden werden.

12. Halbleiterbauelement (27), umfassend einen flächigen Träger (4) mit einer Oberseite (6) und einer Unterseite (7), wobei derTräger (4) eine durchgehende Aussparung (5) aufweist, die zwischen der Oberseite (6) und der Unterseite (7) verläuft, eine Halbleiteranordnung (8), die einen Halbleiterchip (10) aufweist, wobei der Halbleiterchip (10) an einer Unterseite (11) elektrisch und/oder optisch aktive Bereiche (12) umfasst, und eine Vergussmasse (17), durch die die Halbleiteranordnung (8) mit dem Träger (4) stoffschlüssig verbunden ist, wobei die Unterseite (9) der Halbleiteranordnung (8) und die Unterseite (7) des Trägers (4) in einer gemeinsamen Ebene verlaufen,
wobei die Oberseite (6) des Trägers (4) und eine Oberseite (22) der Halbleiteranordnung (8) in einer gemeinsamen Ebene verlaufen, wobei die Halbleiteranordnung (8) an einer Oberseite (22) eine Opferschicht (15) aufweist, **dadurch gekennzeichnet, dass** die Opferschicht (15) metallisches oder halbleitendes Material aufweist.

13. Halbleiterbauelement (27), nach Anspruch 12, **dadurch gekennzeichnet, dass** mindestens 90%, vorzugsweise mindestens 95%, von auf der Oberseite (6) des Trägers (4) und auf der Oberseite (22) der Halbleiteranordnung (8) befindlichen Punkten einen senkrecht zur gemeinsamen Ebene gemessenen Abstand von der gemeinsamen Ebene von höchstens 5 µm, vorzugsweise höchstens 1 µm, aufweisen.

14. Halbleiterbauelement (27) nach einem der Ansprüche 12 oder 13, **dadurch gekennzeichnet, dass** die Halbleiteranordnung (8) eine geschliffene Oberseite (22) aufweist.

## Claims

1. A method for producing a semiconductor component (27), comprising the following steps:
- providing a flat carrier (4) including an upper side (6) and a lower side (7), the carrier (4) including a continuous opening (5) that extends between the upper side (6) and the lower side (7);
- providing a semiconductor arrangement (8) that comprises a semiconductor chip (10), the semiconductor chip (10) comprising electrically and/or optically active regions (12) at a lower side (11);
- arranging the semiconductor arrangement (8) in the opening (5) in such a way that a lower side (9) of the semiconductor arrangement (8) and the lower side (7) of the carrier (4) extend in a common plane;
- potting the semiconductor system (8) with a potting compound (17) in such a way that the semiconductor arrangement (8) is integrally connected to the carrier (4), the semiconductor arrangement (8) together with the carrier (4) and the potting compound (17) forming a semiconductor system (18); and
- thinning the semiconductor system (18) by way of grinding from above in such a way that an upper side (6) of the carrier (4) and an upper side (22) of the semiconductor arrangement (8) extend in a common plane,
the semiconductor arrangement (8) comprising a sacrificial layer (15) on an upper side (22) which is thinned during grinding, **characterized in that** the sacrificial layer (15) comprises metallic or semi-conducting material.

2. The method according to claim 1, **characterized in that** the thinning of the semiconductor system (18) is carried out by removing material from the semiconductor arrangement (8).

3. The method according to either claim 1 or 2, **characterized in that** the thinning of the semiconductor system (18) is carried out by way of material ablation from the carrier (4) and from the semiconductor arrangement (8).

4. A method according to any one of claims 1 to 3, **characterized in that** providing the semiconductor arrangement (8) comprises the following step:
- depositing the sacrificial layer (15) on an upper side (13) of the semiconductor chip (10).

5. A method according to any one of claims 1 to 3, **characterized in that** providing the semiconductor arrangement (8) comprises the following step:
- fastening the sacrificial layer (15) on an upper side (13) of the semiconductor chip (10).

6. A method according to any one of claims 1 to 5, **characterized in that** an auxiliary carrier (1) is provided prior to potting, on which the carrier (4) is arranged, the semiconductor arrangement (8) being arranged on the auxiliary carrier (1) when the semiconductor arrangement (8) is being arranged in the opening (5) of the carrier (4).

7. A method according to any one of claims 1 to 6, **characterized in that** at least one further semiconductor arrangement (8) is provided, which is arranged in the opening (5) and potted into the potting compound (17).

8. A method according to any one of claims 1 to 7, **characterized in that** the carrier (4) comprises a metallic or semi-conducting material, in particular silicon.

9. A method according to any one of claims 1 to 8, **characterized in that**, after the thinning of the semiconductor system (18), the upper side (22) of the semiconductor arrangement (8) is connected at least regionally to a heat sink (28) by way of a thermally conductive contact.

10. A method according to any one of claims 1 to 9, **characterized in that**, after the thinning of the semiconductor system (18), the upper side (22) of the semiconductor arrangement (8) is connected at least regionally to an electrically conductive contact, which is at least regionally electrically conductively connected to an upper side (13) of the semiconductor chip (10).

11. A method according to any one of claims 1 to 10, **characterized by** the following step:
- producing a rewiring layer (29) on a lower side (25) of the semiconductor system (18), the rewiring layer (29) comprising conducting paths (30) which are at least regionally electrically conductively connected to the electrically and/or optically active regions (12) of the semiconductor chip (10).

12. A semiconductor component (27), comprising a flat carrier (4) including an upper side (6) and a lower side (7), the carrier (4) comprising a continuous opening (5) that extends between the upper side (6) and the lower side (7), a semiconductor arrangement (8) that comprises a semiconductor chip (10), the semiconductor chip (10) comprising electrically and/or optically active regions (12) on a lower side (11), and a potting compound (17) by way of which the semiconductor arrangement (8) is integrally connected to the carrier (4), the lower side (9) of the semiconductor arrangement (8) and the lower side (7) of the carrier (4) extending in a common plane,
the upper side (6) of the carrier (4) and an upper side (22) of the semiconductor arrangement (8) extending in a common plane, the semiconductor arrangement (8) comprising a sacrificial layer (15) on an upper side (22), **characterized in that** the sacrificial layer (15) comprises metallic or semi-conducting material.

13. The semiconductor component (27) according to claim 12, **characterized in that** at least 90%, preferably at least 95%, of points located on the upper side (6) of the carrier (4) and on the upper side (22) of the semiconductor arrangement (8) have a distance from the common plane of no more than 5 µm, preferably of no more than 1 µm, measured perpendicularly to the common plane.

14. The semiconductor component (27) according to either claim 12 or 13, **characterized in that** the semiconductor arrangement (8) includes a ground upper side (22).

## Revendications

1. Procédé de fabrication d'un élément semi-conducteur (27) avec les étapes suivantes :
- la mise au point d'un support (4) plan avec une face supérieure (6) et une face inférieure (7), où le support (4) présente un évidement (5) traversant, qui s'étend entre la face supérieure (6) et la face inférieure (7),
- la mise au point d'un ensemble semi-conducteur (8), qui présente une puce semi-conductrice (10), où la puce semi-conductrice (10) comprend des zones (12) d'activité électrique et/ou optique sur une face inférieure (11),
- la disposition de l'ensemble semi-conducteur (8) dans l'évidement (5), de telle manière qu'une face inférieure (9) de l'ensemble semi-conducteur (8) et la face inférieure (7) du support (4) s'étendent dans un plan commun,
- le scellement de l'ensemble semi-conducteur (8) avec une masse de scellement (17), de telle manière que l'ensemble semi-conducteur (8) est relié avec le support (4) par complémentarité des matières, où l'ensemble semi-conducteur (8) avec le support (4) et la masse de scellement (17) forme un système semi-conducteur(18),
- le désépaississement du système semi-conducteur (18) par un ponçage par le haut, de telle manière qu'une face supérieure (6) du support (4) et une face supérieure (22) de l'ensemble semi-conducteur (8) s'étendent dans un plan commun,
où l'ensemble semi-conducteur (8) présente une couche sacrificielle (15) sur une face supérieure (22), qui est désépaissie lors du ponçage, **caractérisé en ce que** la couche sacrificielle (15) présente un matériau métallique ou semi-conducteur.

2. Procédé selon la revendication 1, **caractérisé en ce que** le désépaississement du système semi-conducteur (18) a lieu par un enlèvement de matière de l'ensemble semi-conducteur (8).

3. Procédé selon l'une des revendications 1 ou 2, **caractérisé en ce que** le désépaississement (18) a lieu par prélèvement de matière du support (4) et de l'ensemble semi-conducteur (8).

4. Procédé selon l'une des revendications 1 bis 3, **caractérisé en ce que** la mise au point de l'ensemble semi-conducteur (8) comprend l'étape suivante :
- le dépôt de la couche sacrificielle (15) sur une face supérieure (13) de la puce semi-conductrice (10).

5. Procédé selon l'une des revendications 1 bis 3, **caractérisé en ce que** la mise au point de l'ensemble semi-conducteur (8) comprend l'étape suivante :
- la fixation de la couche sacrificielle (15) sur une face supérieure (13) de la puce semi-conductrice (10).

6. Procédé selon l'une des revendications 1 à 5, **caractérisé en ce qu'**avant le scellement, on prévoit un support auxiliaire (1) sur lequel est disposé le support (4), où l'ensemble semi-conducteur (8), lors de la mise en place de l'ensemble semi-conducteur (8), est déposé dans l'évidement (5) du support (4) sur le support auxiliaire (1).

7. Procédé selon l'une des revendications 1 à 6, **caractérisé en ce qu'**au moins un nouvel ensemble semi-conducteur (8) est mis au point, qui est disposé dans l'évidement (5) et est scellé dans la masse de scellement (17).

8. Procédé selon l'une des revendications 1 à 7, **caractérisé en ce que** le support (4) comprend un matériau métallique ou semi-conducteur, notamment du silicium.

9. Procédé selon l'une des revendications 1 à 8, **caractérisé en ce que** la face supérieure (22) de l'ensemble semi-conducteur (8), après le désépaississement du système semi-conducteur (18), est reliée au moins par endroits par un contact thermoconducteur avec un corps de refroidissement (28).

10. Procédé selon l'une des revendications 1 à 9, **caractérisé en ce que** la face supérieure (22) de l'ensemble semi-conducteur (8), après le désépaississement du système semi-conducteur (18), est reliée au moins par endroits avec un contact conducteur électriquement, qui est relié de manière électriquement conductrice avec une face supérieure (13) de la puce semi-conductrice (10) au moins par endroits.

11. Procédé selon l'une des revendications 1 à 10, **caractérisé par** l'étape :
- de fabrication d'une couche de recâblage (29) sur une face inférieure (25) du système semi-conducteur (18), où la couche de recâblage (29) comprend des pistes semi-conductrices (30) qui sont reliées de manière électriquement conductrice au moins par endroits par des zones (12) actives électriquement et/ou optiquement de la puce semi-conductrice (10).

12. Composant semi-conducteur (27), comprenant un support (4) plan avec une face supérieure (6) et une face inférieure (7), dans lequel le support (4) présente un évidement (5) traversant qui s'étend entre la face supérieure (6) et la face inférieure (7), un ensemble semi-conducteur (8), qui présente une puce semi-conductrice (10), dans lequel la puce semi-conductrice (10) comprend des zones (12) actives électriquement et/ou optiquement sur une face inférieure (11), et une masse de scellement (17), par laquelle l'ensemble semi-conducteur (8) est relié avec le support (4) par complémentarité des matières, dans lequel la face inférieure (9) de l'ensemble semi-conducteur (8) et la face inférieure (7) du support (4) s'étendent dans un plan commun,
dans lequel la face supérieure (6) du support (4) et une face supérieure (22) de l'ensemble semi-conducteur (8) s'étendent dans un plan commun, où l'ensemble semi-conducteur (8) présente au niveau d'une face supérieure (22) une couche sacrificielle (15), **caractérisé en ce que** la couche sacrificielle (15) présente un matériau métallique ou semi-conducteur.

13. Composant semi-conducteur (27) selon la revendication 12, caractérisé e ce que des points se trouvant sur au moins 90 %, de préférence, au moins 95 %, de la face supérieure (6) du support (4) et sur la face supérieure (22) de l'ensemble semi-conducteur (8), présentent une distance mesurée perpendiculairement au plan commun par rapport au plan commun d'au maximum 5 µm, de préférence, d'au maximum 1 µm.

14. Composant semi-conducteur (27) selon l'une des revendications 12 ou 13, **caractérisé en ce que** l'ensemble semi-conducteur (8) présente une face supérieure (22) poncée.
